# EUROPEAN PATENT APPLICATION

(11) **EP 4 739 014 A1**
(43) Date of publication of application: **06.05.2026**
(21) Application number: 25209165.7
(22) Date of filing: 16.10.2025
(51) Int. Cl.: H05K 7/14

(54) **ADAPTER MODULE, CHASSIS AND DATA PROCESSING DEVICE**

(30) Priority: 04.11.2024 TW 113142054
(71) Applicant: Wiwynn Corporation, New Taipei City 22102 (TW)
(72) Inventor: Chang, Chih-Wei, 22102 New Taipei City (TW); Huang, Wei-Li, 22102 New Taipei City (TW)
(74) Representative: Straus, Alexander

(57) **Abstract**

An adapter module (122, 124) is adapted to be disposed in a casing (120) and is electrically connected with or electrically disconnected from at least one electronic component (14, 16). The adapter module (122, 124) includes a bracket (1220, 1240) and an operating member (1222, 1242). The operating member (1222, 1242) is disposed on the bracket (1220, 1240). When the operating member (1222, 1242) is located at a locked position, the bracket (1220, 1240) and the casing (120) are locked and the at least one electronic component (14, 16) is electrically connected to the adapter module (122, 124). When the at least one electronic component (14, 16) is electrically disconnected from the adapter module (122, 124), the operating member (1222, 1242) is able to be converted from the locked position to an unlocked position to unlock the bracket (1220, 1240) from the casing (120).

## Description

### Field of the Invention

The present invention relates to an adapter module, particularly an adapter module facilitating component maintenance and replacement, and a chassis and a data processing device equipped with the adapter module.

### Background of the Invention

With the rise of big data, machine learning, the Internet of Things, and various network platforms, the demand for servers in life is getting higher and higher. When it is necessary to maintain or replace components in the server, due to the heavy weight and large size of the server, the chassis must be removed from the rack first, such that the maintenance and replacement of components become more difficult. Furthermore, the disassembly and transportation of the chassis will also increase the risk to personnel safety.

### Summary of the Invention

The present invention aims at providing an adapter module facilitating component maintenance and replacement, and a chassis and a data processing device equipped with the adapter module, thereby resolving the aforesaid problems.

This is achieved by an adapter module according to claim 1, a chassis according to claim 14, and a data processing device according to claim 15. The dependent claims pertain to corresponding further developments and improvements.

As will be seen more clearly from the detailed description following below, the claimed adapter module is adapted to be disposed in a casing and is electrically connected with or electrically disconnected from at least one electronic component. The adapter module includes a bracket and an operating member. The operating member is disposed on the bracket. When the operating member is located at a locked position, the bracket and the casing are locked and the at least one electronic component is electrically connected to the adapter module. When the at least one electronic component is electrically disconnected from the adapter module, the operating member is able to be converted from the locked position to an unlocked position to unlock the bracket from the casing.

As will be seen more clearly from the detailed description following below, the claimed chassis includes a casing and the aforesaid adapter module. The adapter module is disposed on the casing.

As will be seen more clearly from the detailed description following below, the claimed data processing device comprises a chassis. The chassis comprises a casing and the aforesaid adapter module. The adapter module is disposed on the casing.

### Brief Description of the Drawings

In the following, the invention is further illustrated by way of example, taking reference to the accompanying drawings thereof:
FIG. 1 is a perspective view illustrating a data processing device according to an embodiment of the invention,
FIG. 2 is a perspective view illustrating a chassis shown in FIG. 1,
FIG. 3 is an exploded view illustrating the chassis shown in FIG. 2,
FIG. 4 is a perspective view illustrating an adapter module shown in FIG. 3 from another viewing angle,
FIG. 5 is a perspective view illustrating an operating member located at a locked position,
FIG. 6 is a perspective view illustrating the operating member located at an unlocked position,
FIG. 7 is a perspective view illustrating the operating member shown in FIG. 5 from another viewing angle,
FIG. 8 is an exploded view illustrating the operating member, a fixing base, an engaging pin and an elastic member,
FIG. 9 is a partial enlarged view illustrating the operating member located at the locked position,
FIG. 10 is a partial enlarged view illustrating the operating member located at the unlocked position,
FIG. 11 is a perspective view illustrating the adapter module assembled to a casing,
FIG. 12 is a perspective view illustrating an adapter module shown in FIG. 3 from another viewing angle,
FIG. 13 is a perspective view illustrating an operating member located at a locked position,
FIG. 14 is a perspective view illustrating the adapter module shown in FIG. 13 from another viewing angle,
FIG. 15 is a perspective view illustrating the operating member and an engaging member shown in FIG. 13 from another viewing angle,
FIG. 16 is a perspective view illustrating the operating member located at an unlocked position,
FIG. 17 is a partial rear view illustrating the data processing device shown in FIG. 1, and
FIG. 18 is a perspective view illustrating the adapter module reversely assembled to the casing.

### Detailed Description

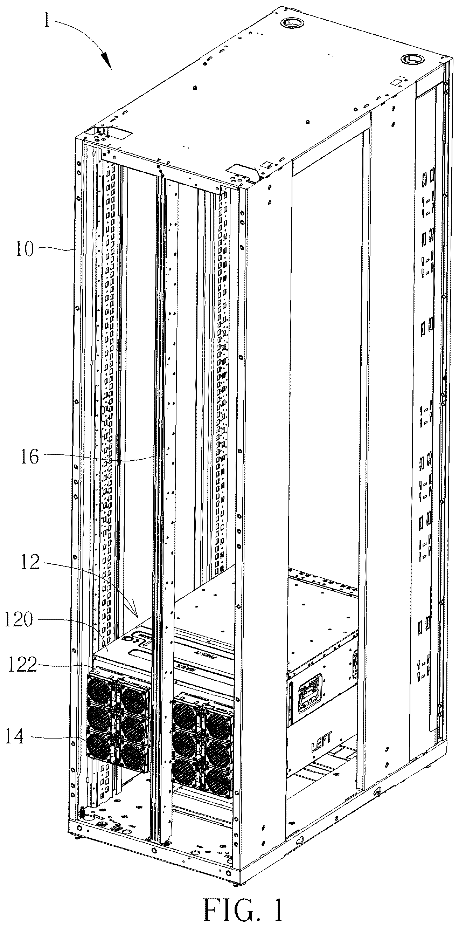

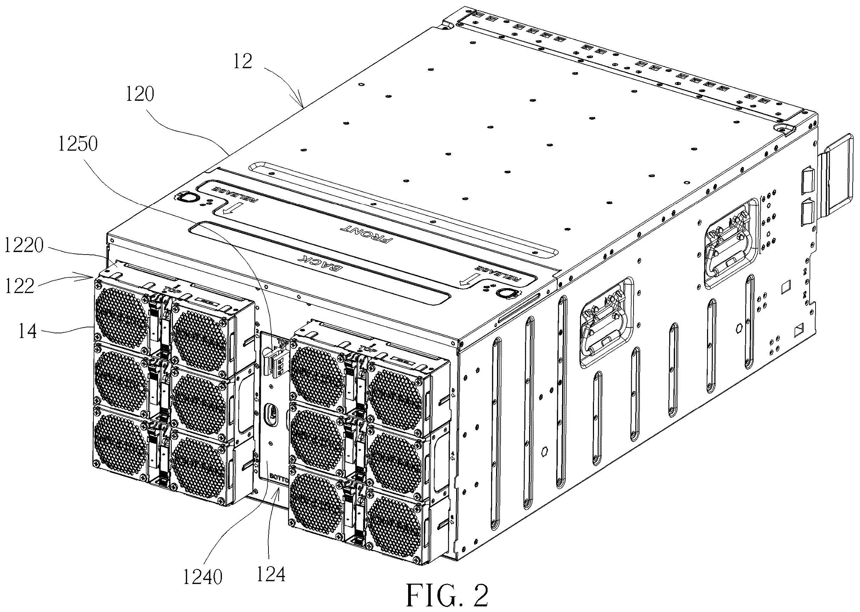

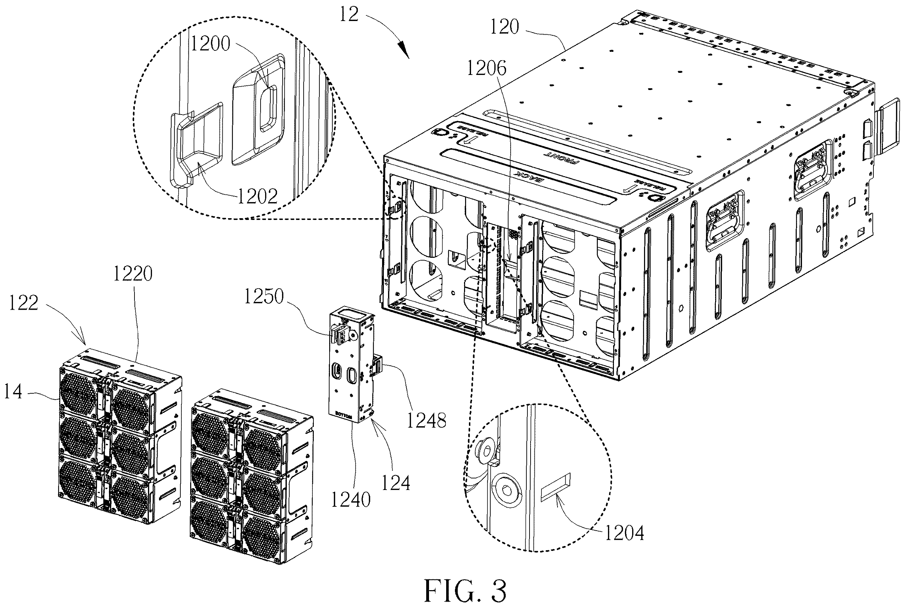

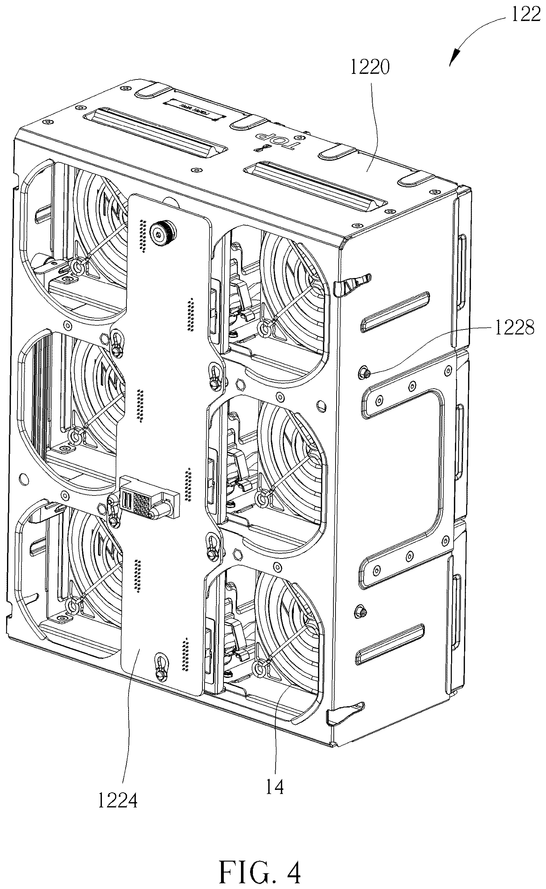

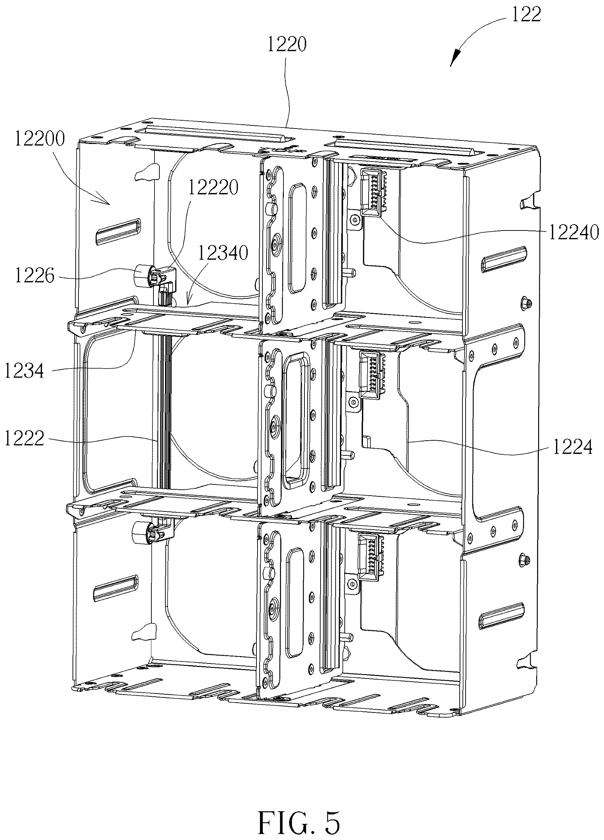

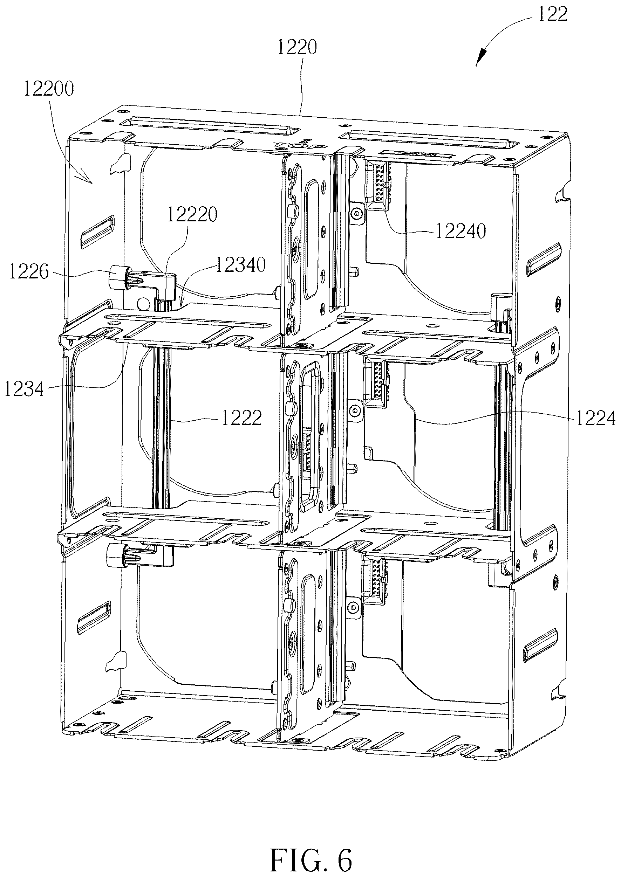

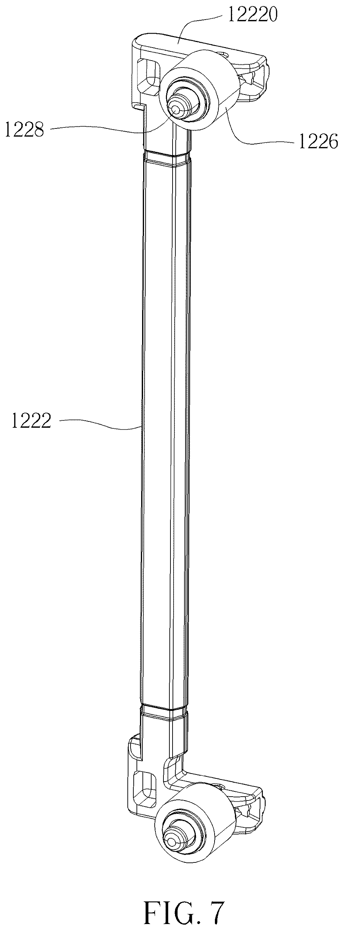

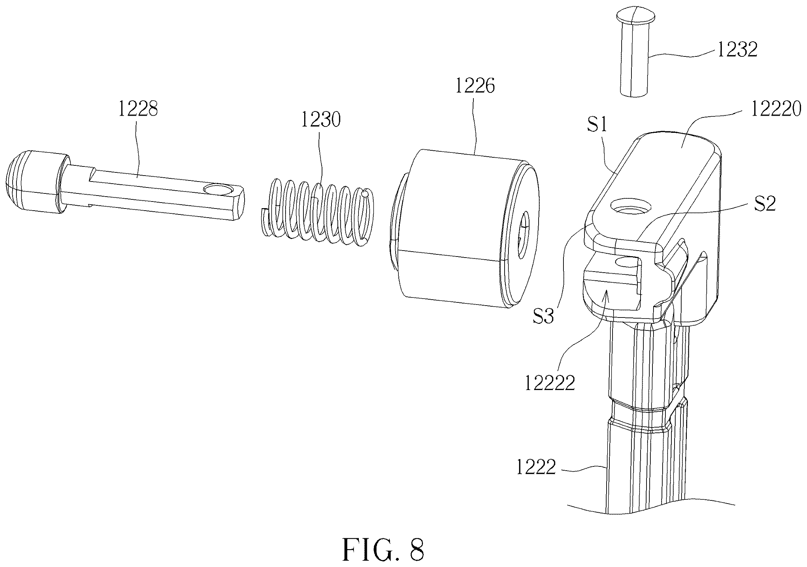

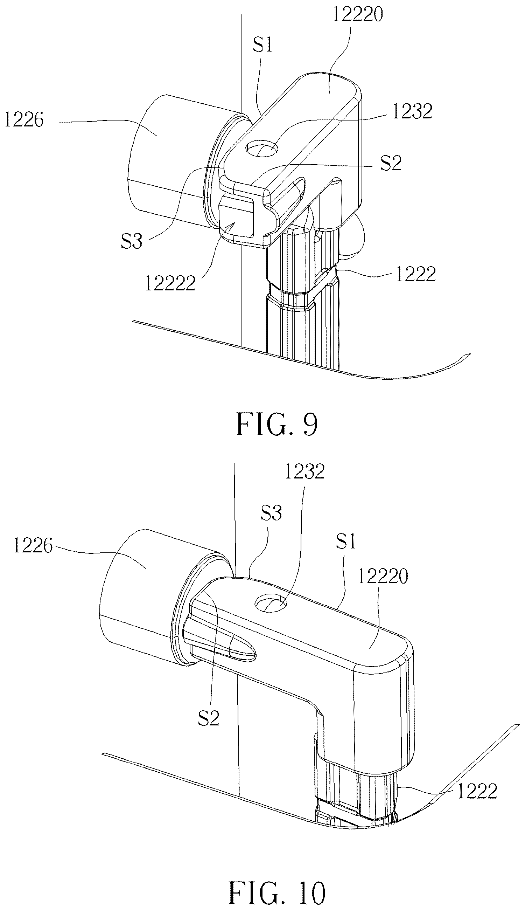

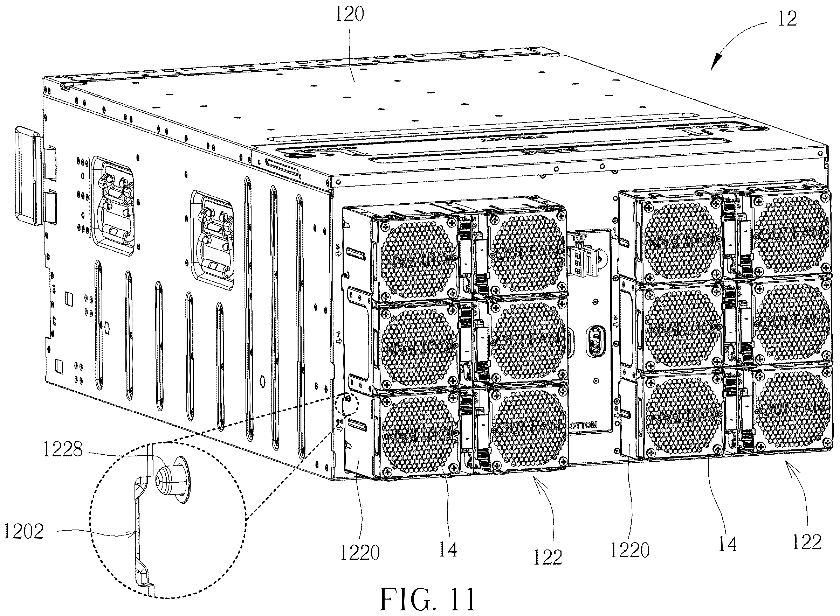

Referring to FIGs. 1 to 11, FIG. 1 is a perspective view illustrating a data processing device 1 according to an embodiment of the invention, FIG. 2 is a perspective view illustrating a chassis 12 shown in FIG. 1, FIG. 3 is an exploded view illustrating the chassis 12 shown in FIG. 2, FIG. 4 is a perspective view illustrating an adapter module 122 shown in FIG. 3 from another viewing angle, FIG. 5 is a perspective view illustrating an operating member 1222 located at a locked position, FIG. 6 is a perspective view illustrating the operating member 1222 located at an unlocked position, FIG. 7 is a perspective view illustrating the operating member 1222 shown in FIG. 5 from another viewing angle, FIG. 8 is an exploded view illustrating the operating member 1222, a fixing base 1226, an engaging pin 1228 and an elastic member 1230, FIG. 9 is a partial enlarged view illustrating the operating member 1222 located at the locked position, FIG. 10 is a partial enlarged view illustrating the operating member 1222 located at the unlocked position, and FIG. 11 is a perspective view illustrating the adapter module 122 assembled to a casing 120.

As shown in FIG. 1, the data processing device 1 comprises a rack 10, a chassis 12 and at least one electronic component 14. The chassis 12 is disposed on the rack 10 and the electronic component 14 is disposed on the chassis 12. The chassis 12 may be a chassis of a server or other electronic devices according to practical applications. As shown in FIGs. 2 and 3, the chassis 12 may comprise a casing 120 and an adapter module 122, wherein the adapter module 122 is disposed on the casing 120. In this embodiment, the chassis 12 may comprise two adapter modules 122 and the two adapter modules 122 may be detachably disposed on opposite sides of the back of the casing 120. It should be noted that the number of adapter modules 122 may be determined according to practical applications, so the invention is not limited to the embodiment shown in the figure.

The adapter module 12 is adapted to be disposed in the casing 120 and is electrically connected with or electrically disconnected from the at least one electronic component 14. As shown in FIGs. 5 and 6, the adapter module 122 comprises a bracket 1220 and an operating member 1222, wherein the operating member 1222 is disposed on the bracket 1220. In this embodiment, the adapter module 122 may comprise two operating members 1222 and the two operating members 1222 are rotatably disposed at opposite sides inside the bracket 1220. Thus, the operating member 1222 may rotate between a locked position shown in FIG. 5 and an unlocked position shown in FIG. 6. In this embodiment, the adapter module 122 may further comprise a circuit board 1224, wherein the circuit board 1224 is disposed at a back side of the bracket 1220, as shown in FIG. 4. The electronic component 14 may be, but is not limited to, a fan electrically connected with or electrically disconnected from the circuit board 1224. Furthermore, the number of electronic components 14 disposed on the bracket 1220 may be determined according to practical applications, so the invention is not limited to the embodiment shown in the figure.

As shown in FIGs. 7 and 8, the adapter module 122 may further comprise a fixing base 1226, an engaging pin 1228 and an elastic member 1230. The fixing base 1226 is fixed on the bracket 1220. In this embodiment, the fixing base 1226 may be fixed on the bracket 1220 by screwing, riveting, welding, engaging or other fixing manners according to practical applications. A driving portion 12220 of the operating member 1222 abuts against the fixing base 1226. The engaging pin 1228 passes through the fixing base 1226 and is pivotally connected to the driving portion 12220. In this embodiment, the driving portion 12220 is formed with a rotating recess 12222, and an end of the engaging pin 1228 is pivotally connected in the rotating recess 12222 by a pivot 1232. The elastic member 1230 is disposed in the fixing base 1226, and two ends of the elastic member 1230 abut against the fixing base 1226 and the engaging pin 1228. In this embodiment, the elastic member 1230 may be a spring or other elastomers according to practical applications. In this embodiment, two ends of the operating member 1222 have two driving portions 12220. Furthermore, corresponding to the two ends of the operating member 1222, the adapter module 122 may comprise two fixing bases 1226, two engaging pins 1228 and two elastic members 1230.

As shown in FIG. 3, the casing 120 may be formed with an engaging hole 1200. In this embodiment, corresponding to two operating members 1222 disposed at two sides of each adapter module 122, the casing 120 may be formed with four engaging holes 1200. When the operating member 1222 rotates between the locked position shown in FIG. 5 and the unlocked position shown in FIG. 6, the driving portion 12220 of the operating member 1222 will drive the engaging pin 1228 to protrude from or retract into the bracket 1220, such that the engaging pin 1228 engages with or disengages from the engaging hole 1200. In this embodiment, the driving portion 12220 has a long side S1, a short side S2 and an arc corner S3, wherein the arc corner S3 connects the long side S1 and the short side S2. The operating member 1222 may smoothly rotate between the locked position shown in FIG. 9 and the unlocked position shown in FIG. 10 through the arc corner S3 of the driving portion 12220. As shown in FIG. 9, when the operating member 1222 is located at the locked position, the long side S1 of the driving portion 12220 abuts against the fixing base 1226. At this time, the engaging pin 1228 protrudes from the bracket 1220. As shown in FIG. 10, when the operating member 1222 is located at the unlocked position, the short side S2 of the driving portion 12220 abuts against the fixing base 1226. At this time, the engaging pin 1228 retracts into the bracket 1220.

As shown in FIGs. 5 and 6, the adapter module 122 may further comprise at least one partition 1234 and the bracket 1220 has an accommodating space 12200. The at least one partition 1234 is disposed in the accommodating space 12200 along a transverse direction of the bracket 1220, and the operating member 1222 is disposed in the accommodating space 12200 along a longitudinal direction of the bracket 1220. In this embodiment, the adapter module 122 may comprise two partitions 1234, but the invention is not so limited. The partition 1234 may be formed with an avoidance recess 12340. The avoidance recess 12340 allows the operating member 1222 to rotate between the locked position shown in FIG. 5 and the unlocked position shown in FIG. 6. Since the operating member 1222 is disposed in the accommodating space 12200 of the bracket 1220, the operating member 1222 rotates between the locked position and the unlocked position within the accommodating space 12200.

When the operating member 1222 is located at the locked position shown in FIG. 5, the engaging pin 1228 protrudes from the bracket 1220 to engage with the engaging hole 1200, such that the bracket 1220 and the casing 120 are locked. At this time, the electronic component 14 may be placed into the bracket 1220, such that the electronic component 14 is electrically connected to the adapter module 122. As shown in FIG. 5, an electrical connector 12240 of the circuit board 1224 is located in the bracket 1220. Thus, when the electronic component 14 is placed into the bracket 1220, the electronic component 14 is connected to the electrical connector 12240 of the circuit board 1224, such that the electronic component 14 is electrically connected with the adapter module 122.

When a user wants to maintain or replace the circuit board 1224, the user may first remove the electronic component 14 from the bracket 1220, such that the electronic component 14 is electrically disconnected from the adapter module 122. When the electronic component 14 is electrically disconnected from the adapter module 122, the operating member 1222 is able to be converted from the locked position shown in FIG. 5 to the unlocked position shown in FIG. 6 to unlock the bracket 1220 from the casing 120. For further explanation, when electronic component 14 is electrically disconnected from the adapter module 122, the user may rotate the operating member 1222 from the locked position shown in FIG. 5 to the unlocked position shown in FIG. 6, such that the engaging pin 1228 disengages from the engaging hole 1200. At this time, the bracket 1220 is unlocked from the casing 120. Then, the user may pull the operating member 1222 to remove the adapter module 122 from the casing 120. Accordingly, the user is able to maintain or replace the circuit board 1224 disposed at the back side of the bracket 1220 without removing the chassis 12 from the rack 10 or removing the casing 120 of the chassis 12. For further explanation, during disassembly, the user needs to first remove the electronic component 14 from the bracket 1220 before operating the operating member 1222 to remove the adapter module 122 from the casing 120. Since the operating member 1222 is hidden inside the bracket 1220, the sequence of disassembling the electronic component 14 and the adapter module 122 can be ensured to prevent the electronic component 14 from being damaged due to incorrect operation.

When the operating member 1222 is located at the unlocked position shown in FIG. 6 and the electronic component 14 is assembled into the bracket 1220, the electronic component 14 will push the operating member 1222 to rotate from the unlocked position shown in FIG. 6 to the locked position shown in FIG. 5, such that the bracket 1220 and the casing 120 are locked. In other words, even if the operating member 1222 is located at the unlocked position shown in FIG. 6, the user can still assemble the electronic component 14 into the bracket 1220.

As shown in FIGs. 3 and 11, the casing 120 may be formed with an assembly recess 1202. In this embodiment, corresponding to two operating members 1222 disposed at two sides of each adapter module 122, the casing 120 may be formed with four assembly recesses 1202. When the adapter module 122 is normally assembled to the casing 120 (as the adapter module 122 shown on the right side of FIG. 11), the assembly recess 1202 allows the engaging pin 1228 to pass, such that the adapter module 122 can be assembled with the casing 120. When the adapter module 122 is reversely assembled to the casing 120 (as the adapter module 122 shown on the left side of FIG. 11), the engaging pin 1228 is misaligned with the assembly recess 1202, such that the adapter module 122 cannot be assembled with the casing 120. Accordingly, the assembly recess 1202 may achieve a fool-proof function to avoid incorrect assembly. It should be noted that the number of engaging pins 1228 and assembly recesses 1202 in the invention is not limited.

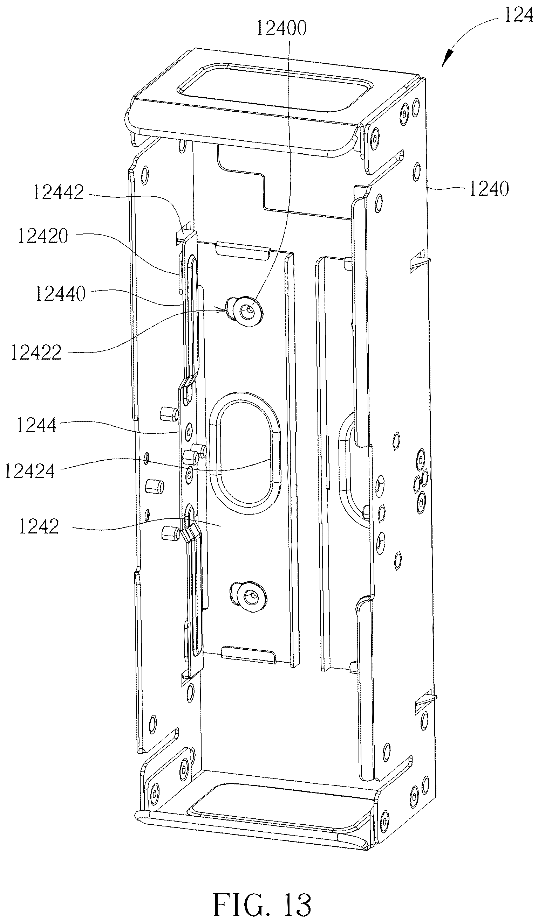

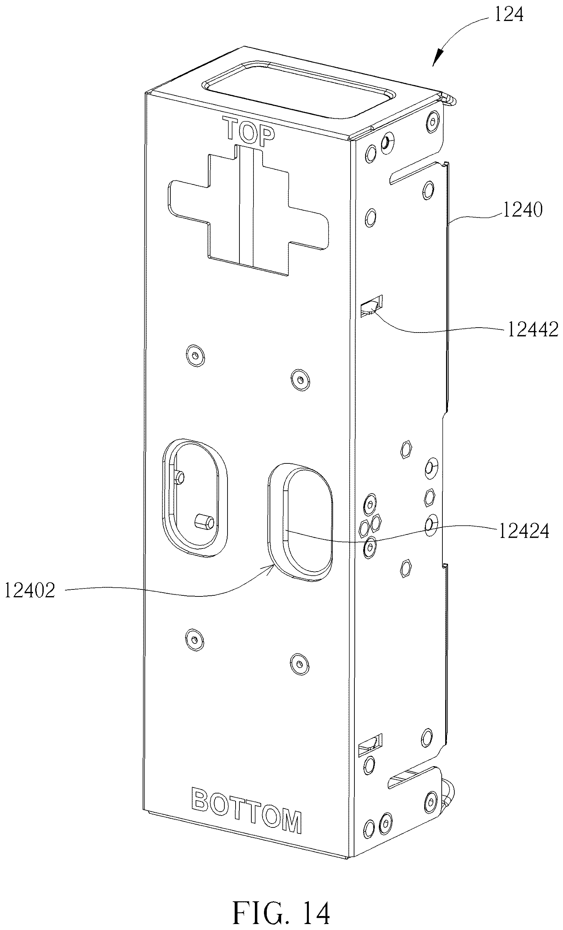

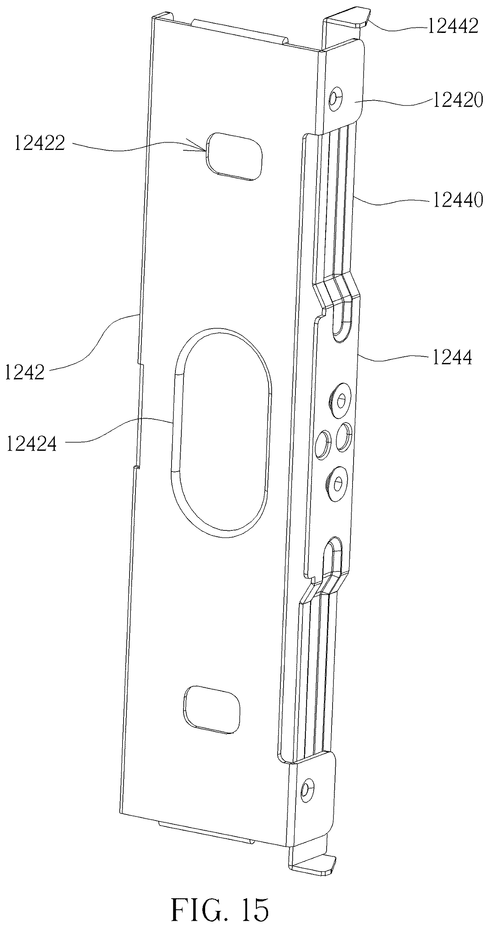

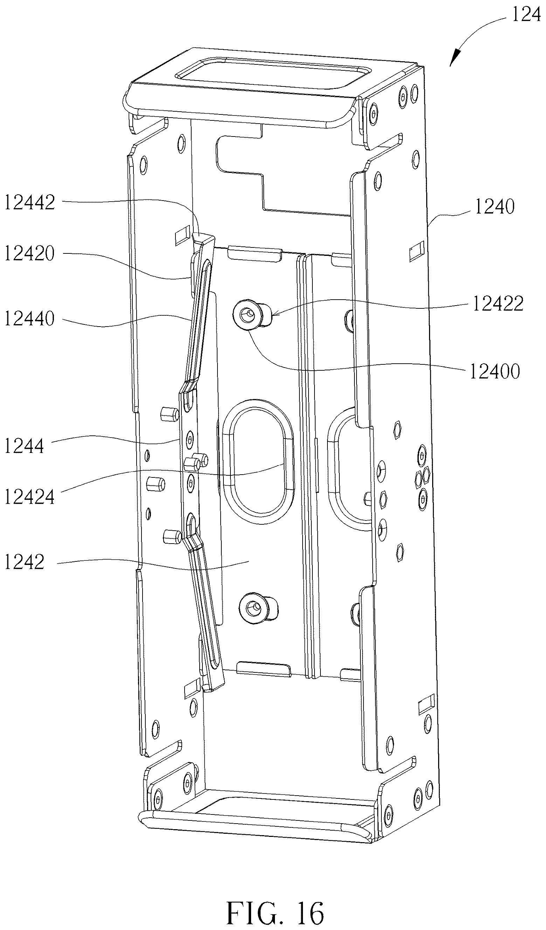

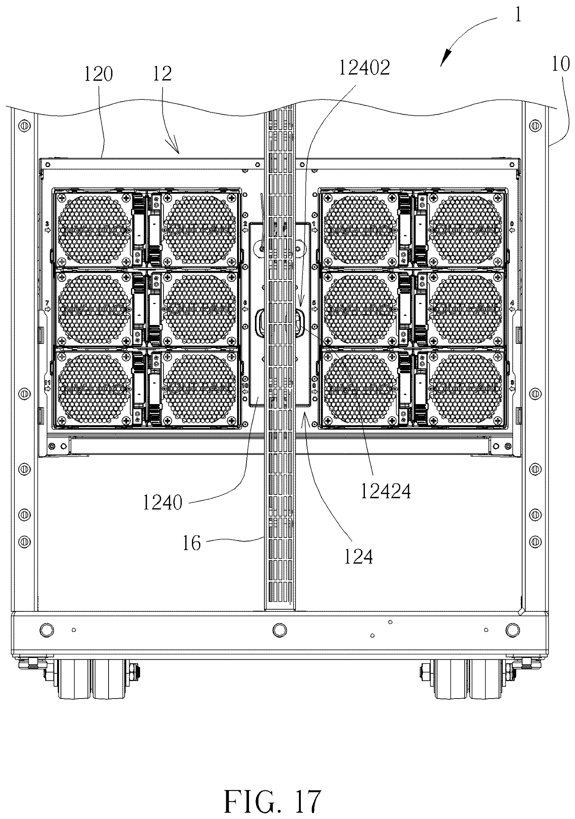

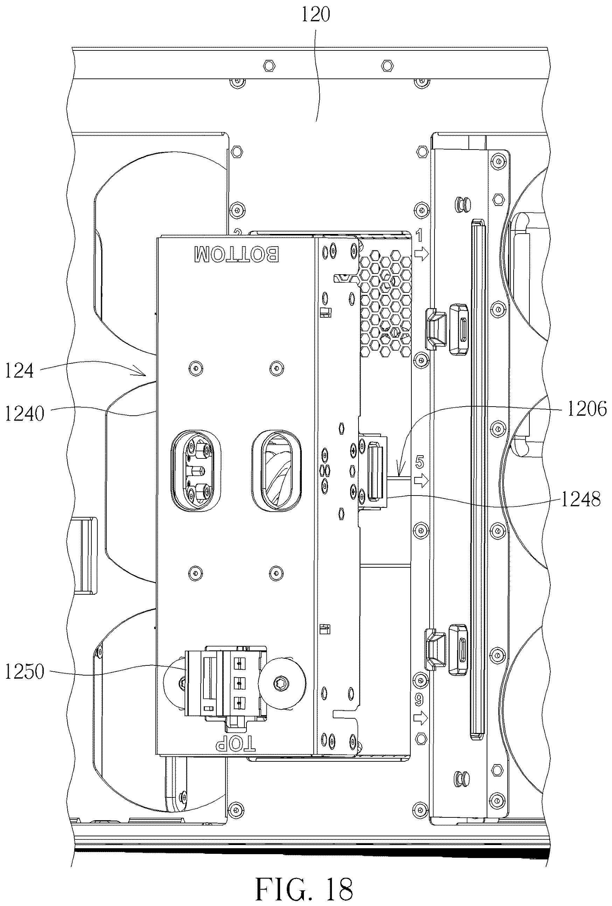

Referring to FIGs. 1 to 3 and FIGs. 12 to 18, FIG. 12 is a perspective view illustrating an adapter module 124 shown in FIG. 3 from another viewing angle, FIG. 13 is a perspective view illustrating an operating member 1242 located at a locked position, FIG. 14 is a perspective view illustrating the adapter module 124 shown in FIG. 13 from another viewing angle, FIG. 15 is a perspective view illustrating the operating member 1242 and an engaging member 1244 shown in FIG. 13 from another viewing angle, FIG. 16 is a perspective view illustrating the operating member 1242 located at an unlocked position, FIG. 17 is a partial rear view illustrating the data processing device 1 shown in FIG. 1, and FIG. 18 is a perspective view illustrating the adapter module 124 reversely assembled to the casing 120.

As shown in FIG. 1, the data processing device 1 may further comprise an electronic component 16 and the electronic component 16 is disposed on the rack 10. In this embodiment, the electronic component 16 may be, but is not limited to, a busbar. Furthermore, as shown in FIGs. 2 and 3, the chassis 12 may further comprise an adapter module 124, wherein the adapter module 124 is disposed on the casing 120. In this embodiment, the adapter module 124 may be located between two adapter modules 122, but the invention is not so limited.

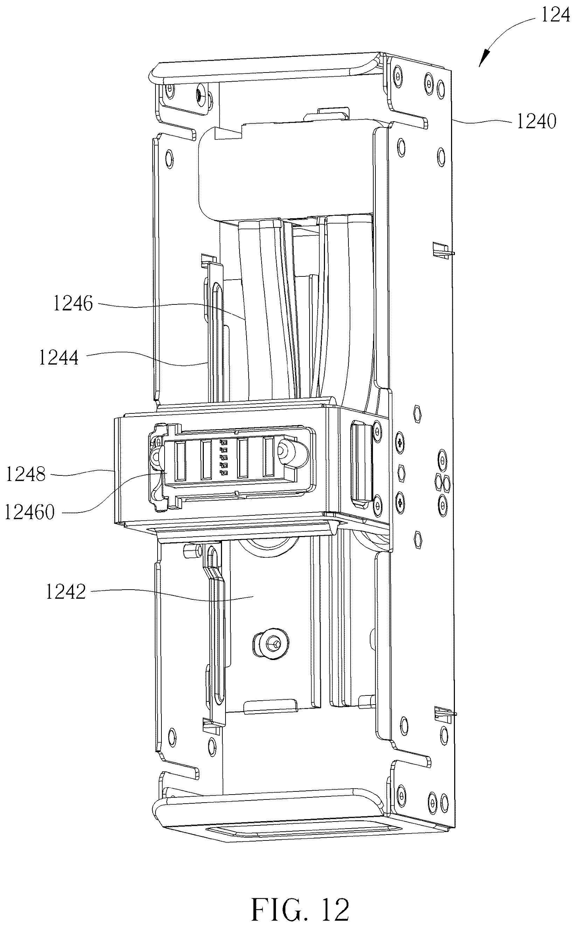

The adapter module 124 is adapted to be disposed in the casing 120 and is electrically connected with or electrically disconnected from the electronic component 16. As shown in FIGs. 12 to 16, the adapter module 124 comprises a bracket 1240, an operating member 1242, an engaging member 1244, a power cable 1246 and a frame 1248. The operating member 1242 is disposed on the bracket 1240. In this embodiment, the adapter module 124 may comprise two operating members 1242 and the two operating members 1242 are movably disposed at opposite sides inside the bracket 1240. Thus, the operating member 1242 may move between a locked position shown in FIG. 13 and an unlocked position shown in FIG. 16.

As shown in FIGs. 13 and 15, the engaging member 1244 is fixed on the bracket 1240, and the engaging member 1244 has an elastic arm 12440 and an engaging portion 12442 extending from the elastic arm 12440. A driving portion 12420 of the elastic member 1242 abuts against the elastic arm 12440. In this embodiment, two ends of the operating member 1242 have two driving portions 12420. Furthermore, corresponding to the two ends of the operating member 1242, the engaging member 1244 may have two elastic arms 12440 and two engaging portions 12442.

As shown in FIG. 3, the casing 120 may be formed with another engaging hole 1204. In this embodiment, corresponding to two operating members 1242 disposed at opposite sides of the adapter module 124, the casing 120 may be formed with four engaging holes 1204. When the operating member 1242 rotates between the locked position shown in FIG. 13 and the unlocked position shown in FIG. 16, the driving portion 12420 of the operating member 1242 will drive the elastic arm 12440 to make the engaging portion 12442 protrude from or retract into the bracket 1240, such that the engaging portion 12442 engages with or disengages from the engaging hole 1204. It should be noted that the number of engaging portions 12442 and engaging holes 1204 in the invention is not limited.

As shown in FIGs. 13 and 16, the bracket 1240 may have a sliding portion 12400 and the operating member 1242 may be formed with a sliding groove 12422. The sliding portion 12400 is disposed in the sliding groove 12422, such that the operating member 1242 is movably disposed on the bracket 1240. In this embodiment, the bracket 1240 may have two sliding portions 12400 and the operating member 1242 may be formed with two sliding grooves 12422. However, the invention is not so limited.

As shown in FIG. 14, the bracket 1240 may be formed with a through hole 12402 and the operating member 1242 may have an operating portion 12424. The operating portion 12424 is exposed in the through hole 12402. Corresponding to two operating members 1242, the bracket 1240 may be formed with two through holes 12402. Thus, a user may insert two fingers into the two through holes 12402 and then press the two operating members 1242 toward each other, such that the two operating members 1242 move to the unlocked position shown in FIG. 16. At this time, the driving portion 12420 of the operating member 1242 will drive the elastic arm 12440 to deform elastically, such that the engaging portion 12442 retracts into the bracket 1240. When the operating member 1242 is released, the elastic arm 12440 will return to the state shown in FIG. 13, such that the operating member 1242 move to the locked position shown in FIG. 13.

As shown in FIG. 12, the power cable 1246 is disposed in the bracket 1240 and the frame 1248 is connected to the bracket 1240. In this embodiment, the power cable 1246 may comprise an electrical connector 12460 disposed in the frame 1248. As shown in FIG. 2, when the adapter module 124 is assembled to the casing 120, the electrical connector 12460 may be connected to a circuit board (not shown) in the casing 120 to form electrical connection. In this embodiment, the electronic component 16 shown in FIG. 1 may be a busbar electrically connected with or electrically disconnected from the power cable 1246. As shown in FIG. 2, the adapter module 124 may further comprise a power clip 1250, wherein the power clip 1250 is connected to the power cable 1246. The electronic component 16 may be connected with or disconnected from the power clip 1250, so as to be connected with or disconnected from the power cable 1246.

As shown in FIG. 17, when the chassis 12 is disposed on the rack 10 and the electronic component 16 is electrically connected to the adapter module 124, the electronic component 16 covers at least a portion of the through hole 12402. Accordingly, it may prevent the adapter module 124 from being taken out by misoperation and causing malfunction.

When a user wants to maintain or replace the power cable 1246, the user may first disconnect the electronic component 16 from the power clip 1250, such that the electronic component 16 is electrically disconnected from the power cable 1246. When the electronic component 16 is electrically disconnected from the power cable 1246, the operating member 1242 is able to be converted from the locked position shown in FIG. 13 to the unlocked position shown in FIG. 16 to unlock the bracket 1240 from the casing 120. For further explanation, when electronic component 16 is electrically disconnected from the adapter module 124, the through hole 12402 is not covered by the electronic component 16 anymore. The user may press the operating member 1242 to make the operating member 1242 move from the locked position shown in FIG. 13 to the unlocked position shown in FIG. 16, such that the engaging portion 12442 disengages from the engaging hole 1204. At this time, the bracket 1240 is unlocked from the casing 120. Then, the user may remove the adapter module 124 from the casing 120. Accordingly, the user is able to maintain or replace the power cable 1246 disposed in the bracket 1240 without removing the chassis 12 from the rack 10 or removing the casing 120 of the chassis 12. For further explanation, during disassembly, the user needs to first disconnect the electronic component 16 from the power cable 1246 before operating the operating member 1242 to remove the adapter module 124 from the casing 120. Since the operating member 1242 is hidden inside the bracket 1240, the sequence of disassembling the electronic component 16 and the adapter module 124 can be ensured to prevent the electronic component 16 from being damaged due to incorrect operation.

As shown in FIGs. 3 and 18, the casing 120 may be formed with an assembly hole 1206. When the adapter module 124 is normally assembled to the casing 120 (as shown in FIG. 3), the assembly hole 1206 allows the frame 1248 and the electrical connector 12460 to pass, such that the adapter module 124 can be assembled with the casing 120. When the adapter module 124 is reversely assembled to the casing 120 (as shown in FIG. 18), the frame 1248 and the electrical connector 12460 are misaligned with the assembly hole 1206, such that the adapter module 124 cannot be assembled with the casing 120. Accordingly, the assembly hole 1206 may achieve a fool-proof function to avoid incorrect assembly.

As mentioned above, the user may remove the adapter module from the casing of the chassis, so as to maintain or replace the components (e.g. circuit board, power cable, etc.) disposed on the bracket of the adapter module without removing the casing of the chassis. Since the operating member is hidden inside the bracket of the adapter module, the sequence of disassembling the electronic component and the adapter module can be ensured to prevent the electronic component from being damaged due to incorrect operation. Furthermore, the invention may achieve a fool-proof function by the assembly recess/assembly hole to avoid incorrect assembly.

## Claims

1. An adapter module (122, 124) adapted to be disposed in a casing (120) and electrically connected with or electrically disconnected from at least one electronic component (14, 16), **characterized by** the adapter module (122, 124) comprising:
a bracket (1220, 1240); and
an operating member (1222, 1242) disposed on the bracket (1220, 1240);
wherein, when the operating member (1222, 1242) is located at a locked position, the bracket (1220, 1240) and the casing (120) are locked and the at least one electronic component (14, 16) is electrically connected to the adapter module (122, 124);
wherein, when the at least one electronic component (14, 16) is electrically disconnected from the adapter module (122, 124), the operating member (1222, 1242) is able to be converted from the locked position to an unlocked position to unlock the bracket (1220, 1240) from the casing (120).

2. The adapter module (122) of claim 1 further **characterized in that** the adapter module (122) further comprises a fixing base (1226) and an engaging pin (1228), wherein the fixing base (1226) is fixed on the bracket (1220), a driving portion (12220) of the operating member (1222) abuts against the fixing base (1226), the engaging pin (1228) passes through the fixing base (1226) and is pivotally connected to the driving portion (12220), and the casing (120) is formed with an engaging hole (1200); wherein, when the operating member (1222) rotates between the locked position and the unlocked position, the driving portion (12220) drives the engaging pin (1228) to protrude from or retract into the bracket (1220), such that the engaging pin (1228) engages with or disengages from the engaging hole (1200).

3. The adapter module (122) of claim 2 further **characterized in that** the adapter module (122) further comprises an elastic member (1230) disposed in the fixing base (1226), wherein two ends of the elastic member (1230) abut against the fixing base (1226) and the engaging pin (1228).

4. The adapter module (122) of claim 2 or 3 further **characterized in that** the driving portion (12220) has a long side (S1), a short side (S2) and an arc corner (S3), and the arc corner (S3) connects the long side (S1) and the short side (S2); wherein, when the operating member (1222) is located at the locked position, the long side (S1) abuts against the fixing base (1226); wherein, when the operating member (1222) is located at the unlocked position, the short side (S2) abuts against the fixing base (1226).

5. The adapter module (122) of any of claims 2 to 4 further **characterized in that** the driving portion (12220) is formed with a rotating recess (12222), and an end of the engaging pin (1228) is pivotally connected in the rotating recess (12222) by a pivot (1232).

6. The adapter module (122) of any of claims 2 to 5 further **characterized in that** the casing (120) is formed with an assembly recess (1202) allowing the engaging pin (1228) to pass; wherein, when the adapter module (122) is reversely assembled to the casing (120), the engaging pin (1228) is misaligned with the assembly recess (1202).

7. The adapter module (122) of any of the preceding claims further **characterized in that** the adapter module (122) further comprises at least one partition (1234), wherein the bracket (1220) has an accommodating space (12200), the at least one partition (1234) is disposed in the accommodating space (12200) along a transverse direction of the bracket (1220), the operating member (1222) is disposed in the accommodating space (12200) along a longitudinal direction of the bracket (1220), and the at least one partition (1234) is formed with an avoidance recess (12340) allowing the operating member (1222) to rotate between the locked position and the unlocked position.

8. The adapter module (122) of any of the preceding claims further **characterized in that**, when the operating member (1222) is located at the unlocked position and the at least one electronic component (14) is assembled into the bracket (1220), the at least one electronic component (14) pushes the operating member (1222) to rotate from the unlocked position to the locked position.

9. The adapter module (122) of any of the preceding claims further **characterized in that** the adapter module (122) further comprises a circuit board (1224) disposed at a back side of the bracket (1220), wherein the at least one electronic component (14) is a fan electrically connected with or electrically disconnected from the circuit board (1224).

10. The adapter module (124) of claim 1 further **characterized in that** the adapter module (124) further comprises an engaging member (1244) fixed on the bracket (1240), wherein the engaging member (1244) has an elastic arm (12440) and an engaging portion (12442) extending from the elastic arm (12440), a driving portion (12420) of the operating member (1242) abuts against the elastic arm (12440), and the casing (120) is formed with an engaging hole (1204); wherein, when the operating member (1242) rotates between the locked position and the unlocked position, the driving portion (12420) drives the elastic arm (12440) to make the engaging portion (12442) protrude from or retract into the bracket (1240), such that the engaging portion (12442) engages with or disengages from the engaging hole (1204).

11. The adapter module (124) of claim 1 or 10 further **characterized in that** the bracket (1240) has a sliding portion (12400), the operating member (1242) is formed with a sliding groove (12422), and the sliding portion (12400) is disposed in the sliding groove (12422).

12. The adapter module (124) of any of claims 1, 10 and 11 further **characterized in that** the bracket (1240) is formed with a through hole (12402), the operating member (1242) has an operating portion (12424), and the operating portion (12424) is exposed in the through hole (12402); wherein, when the at least one electronic component (16) is electrically connected to the adapter module (124), the at least one electronic component (16) covers at least a portion of the through hole (12402).

13. The adapter module (124) of any of claims 1 and 10-12 further **characterized in that** the adapter module (124) further comprises a power cable (1246) disposed in the bracket (1240), wherein the at least one electronic component (16) is a busbar electrically connected with or electrically disconnected from the power cable (1246), the power cable (1246) comprises an electrical connector (12460) and the casing (120) is formed with an assembly hole (1206) allowing the electrical connector (12460) to pass; wherein, when the adapter module (124) is reversely assembled to the casing (120), the electrical connector (12460) is misaligned with the assembly hole (1206).

14. A chassis (12) **characterized by** the chassis (12) comprising:
a casing (120); and
the adapter module (122, 124) of any of claims 1 to 13 disposed on the casing (120).

15. A data processing device (1) **characterized by** the data processing device (1) comprising:
a chassis (12) comprising a casing (120) and the adapter module (122, 124) of any of claims 1 to 13 disposed on the casing (120).
